(19) Europäisches Patentamt
European Patent Office
Office européen des brevets

(11) **EP 3 951 863 A1**

(12) **EUROPÄISCHE PATENTANMELDUNG**

(43) Veröffentlichungstag:
**09.02.2022  Patentblatt 2022/06**

(21) Anmeldenummer: **20189973.9**

(22) Anmeldetag: **07.08.2020**

(51) Internationale Patentklassifikation (IPC):
**H01L 23/367** (2006.01)

(52) Gemeinsame Patentklassifikation (CPC):
**H01L 23/367**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Müller, Volker**
 **90408 Nürnberg (DE)**
• **Neugebauer, Stephan**
 **91058 Erlangen (DE)**

(54) **KONTAKTSYSTEM MIT ZUVERLÄSSIGER ISOLIERUNG**

(57) Die Erfindung betrifft einen Grundkörper (1), wobei der Grundkörper (1) zur Kontaktierung mit einem Auflagekörper (2), insbesondere zur elektrisch isolierten und/oder wärmeleitenden Kontaktierung mit einem Auflagekörper (2), eine erste Oberfläche (10) aufweist. Zur Verbesserung der Kontaktierung wird vorgeschlagen, dass die erste Oberfläche (10) mindestens eine Ausnehmung (11) aufweist, wobei die Ausnehmung (11) zumindest abschnittsweise in einem Bereich der ersten Oberfläche (10) angeordnet ist, der für die Kontaktierung mit dem Rand einer Kontaktfläche (21) des Auflagekörpers (2) vorgesehen ist. Die Erfindung betrifft weiter ein Kontaktsystem (3) aufweisend einen derartigen Grundkörper (1) und ein Auflagekörper (2), wobei eine Kontaktfläche (21) des Auflagekörpers (2) derart an dem Grundkörper (1) angeordnet ist, dass die Ausnehmung (11) des Grundkörpers (1) sich zumindest abschnittsweise entlang des Randes der Kontaktfläche (21) erstreckt. Ferner betrifft die Erfindung ein Verfahren zur Herstellung eines derartigen Kontaktsystems (3), wobei der Auflagekörper (2) derart auf dem Grundkörper (1) platziert wird, dass zumindest ein Teil des Randes der Kontaktfläche (21) des Auflagekörpers (2) sich entlang der Ausnehmung (11) des Grundkörpers (1) erstreckt.

FIG 3

EP 3 951 863 A1

**Beschreibung**

Die Erfindung betrifft einen Grundkörper, wobei der Grundkörper zur Kontaktierung, insbesondere zur elektrisch isolierten und/oder wärmeleitenden Kontaktierung, mit einem Auflagekörper eine erste Oberfläche aufweist. Ferner betrifft die Erfindung ein Kontaktsystem aufweisend einen derartigen Grundkörper und einen Auflagekörper. Die Erfindung betrifft weiter ein Verfahren zur Herstellung eines derartigen Kontaktsystems.

Beim Aufbau elektrischer Geräte oder Komponenten stellt sich oftmals die Aufgabe, zwei Körper, beispielsweise einen Grundkörper und einen Auflagekörper, mechanisch und teilweise auch thermisch miteinander zu verbinden. Um diese Verbindung, auch als Kontaktierung bezeichnet, elektrisch isolierend auszuführen, können die zwei unterschiedliches elektrisches Potenzial führende Bauteile durch eine Isolierschicht mit elektrisch isolierender Wirkung getrennt werden.

Es hat sich gezeigt, dass diese Isolierschicht bei der Kontaktierung oder im Betrieb des Gerätes bzw. der Komponente, Schädigungen erfährt und dann, schlagartig oder schleichend über die Zeit, die elektrisch isolierende Wirkung dadurch verliert.

Der Erfindung liegt die Aufgabe zugrunde, ein Kontaktsystem für eine Kontaktierung, insbesondere eine elektrisch isolierende Kontaktierung, zu verbessern.

Diese Aufgabe wird durch einen Grundkörper gelöst, wobei der Grundkörper zur Kontaktierung mit einem Auflagekörper, insbesondere zur elektrisch isolierten und/oder wärmeleitenden Kontaktierung mit einem Auflagekörper, eine erste Oberfläche aufweist, wobei die erste Oberfläche mindestens eine Ausnehmung aufweist, wobei die Ausnehmung zumindest abschnittsweise in einem Bereich der ersten Oberfläche angeordnet ist, der für die Kontaktierung mit dem Rand einer Kontaktfläche des Auflagekörpers vorgesehen ist. Ferner wird diese Aufgabe durch ein Kontaktsystem aufweisend einen derartigen Grundkörper und einen Auflagekörper gelöst, wobei eine Kontaktfläche des Auflagekörpers derart an dem Grundkörper angeordnet ist, dass die Ausnehmung des Grundkörpers sich zumindest abschnittsweise entlang des Randes der Kontaktfläche erstreckt. Die Aufgabe wird weiter durch ein Verfahren zur Herstellung eines derartigen Kontaktsystems gelöst, wobei der Auflagekörper derart auf dem Grundkörper platziert wird, dass zumindest ein Teil des Randes der Kontaktfläche des Auflagekörpers sich entlang der Ausnehmung des Grundkörpers erstreckt.

Weitere vorteilhafte Ausgestaltungen der Erfindung sind in den abhängigen Ansprüchen angegeben.

Der Erfindung liegt unter anderem die Erkenntnis zugrunde, dass sich die elektrisch isolierende Wirkung deutlich insbesondere hinsichtlich ihrer Zuverlässigkeit und Langlebigkeit verbessern lässt, wenn an dem Grundkörper an der für die Kontaktierung mit dem Auflagekörper vorgesehenen Stelle, eine Ausnehmung vorhanden ist. Es hat sich gezeigt, dass beispielsweise durch Bauteilfehler, wie beispielsweise durch Schneidprozesse entstandene Grate, die Gefahr der Beschädigung der Isolierschicht entsteht. Die Gefahr wächst mit der Kraft, mit der der Auflagekörper während der Montage und/oder dauerhaft auf den Grundkörper gedrückt wird. Meist ist die Isolierschicht dünn und/oder weich, so dass ein Grat zu einer Veränderung und/oder Beschädigung der Isolierschicht führen kann. Dabei kann die elektrisch isolierende Wirkung schlagartig verloren gehen oder auch über die Zeit abnehmen.

Diese Isolierschicht mit elektrisch isolierender Wirkung stellt sicher, dass auch bei unterschiedlichen elektrischen Potenzialen von Grundkörper und Auflagekörper kein elektrischer Strom fließt.

Auch für den Fall, dass der Auflagekörper direkt auf dem Grundkörper angeordnet ist, also ohne dazwischenliegende Isolierschicht, auch als isolierschichtfrei bezeichnet, bietet die Ausnehmung Vorteile. Aufgrund der vorhandenen mechanischen Fehler an der Oberfläche wie beispielsweise Grate liegen die beiden Körper, Grundkörper und Auflagekörper nicht plan aneinander an. Das kann das Betriebsverhalten negativ beeinflussen. Beispielsweise verschlechtert sich ein Wärmeübergang von einer elektrischen oder elektronischen Komponente zu einem Kühlkörper dadurch. Dadurch kann unter Umständen die Entwärmung nicht mehr sichergestellt werden. Eine Verkürzung der Lebensdauer oder Ausfall der Komponente ist die Folge. Mit anderen Worten kann durch die Ausnehmung des Grundkörpers sichergestellt werden, dass Grundkörper und Auflagekörper an der Kontaktfläche außerhalb der Ausnehmung plan aneinander anliegen und ein guter Wärmeübergang erzielt wird.

Durch die Ausnehmung an der ersten Oberfläche des Grundkörpers kann die negative Wirkung der Grate weitestgehend vermieden werden. Durch die Ausnehmungen führen die Überhöhungen aufgrund der Grate am Rand der Kontaktfläche nicht mehr zu einem wenn auch geringen Abstand zwischen Grundkörper und Auflagekörper. Die Unebenheiten werden durch die Ausnehmungen aufgenommen, der übrige plane Teil der Kontaktfläche des Auflagekörpers liegt dann plan am Grundkörper an. Dadurch entsteht beispielsweise auch ein besonders guter Wärmeübergang zwischen Grundkörper und Auflagekörper.

Die schädigende Wirkung der Grate auf eine Isolierschicht kann ebenfalls durch die Ausnehmungen beseitigt oder zumindest deutlich verringert werden, wenn an der betreffenden Stelle der Kontaktfläche, also insbesondere am Rand der Kontaktfläche des Auflagekörpers, keine Gegenkraft durch den Grundkörper entsteht. Dann wirkt auch keine Kraft oder nur eine geringe Kraft auf die dazwischenliegende Isolierschicht. Dies wird durch die Ausnehmung bewirkt. Vorteilhafterweise ist die Ausnehmung derart an der ersten Oberfläche angeordnet, dass sie sich entlang des Randes der Kontaktfläche des Auflagekörpers erstreckt. In diesem Fall wird zuverlässig verhindert, dass ein am Rand der Kontaktfläche des Auflagekörpers vorhandener Grat die Isolierschicht beschädigt und/oder zerstört.

Dabei kann es vorteilhaft sein, nur eine Ausnehmung an einer Stelle vorzunehmen, der nur einem Teil des Randes der Kontaktfläche des Auflagekörpers entspricht. Für den Fall, dass beispielsweise nur an wenigen Stellen des Auflagekörpers die Gefahr von mechanischen Störungen, wie beispielsweise ein Grat, vorhanden ist, kann sich die Ausnehmung auf den Bereich beschränken, an dem der für die Kontaktierung vorgesehene Rand der Kontaktfläche des Auflagekörpers eine erhöhte Gefahr für das Vorhandenseins eines Grates aufweist.

Es hat sich gezeigt, dass die Gefahr der Beschädigung der Isolierschicht größer ist, je größer die Abmessungen des Auflagekörpers, insbesondere je größer die Abmessungen der Kontaktfläche des Auflagekörpers, sind. Insbesondere auch eine größere Randlänge erhöht das Risiko einer Beschädigung.

Durch die Ausnehmungen auf dem Grundkörper ist es möglich, die Anforderungen, beispielsweise in Form einer Bauteilspezifikation, an eine Gratfreiheit zu reduzieren. Damit können die Fertigungskosten des betreffenden Bauteils reduziert werden. Da eine Gratfreiheit nicht immer gewährleistet werden kann, reduziert sich der Ausschuss bzw. der Aufwand an Nacharbeit, insbesondere von manueller Nacharbeit, für die Sicherstellung der erforderlichen Qualität. Ebenso können Qualitätstests im Rahmen der Montage vereinfacht werden.

Darüber hinaus ergibt sich der Vorteil, dass die Isolierschicht dünner ausgeführt sein kann. Durch die Ausnehmungen und damit die geringere oder nicht mehr vorhandene Kraft an den Graten der Kontaktfläche ist die Gefahr der Beschädigung der Isolierschicht so gering, dass auf eine vorsorglich zur Sicherstellung der elektrischen Isolationswirkung ausgeführten dickeren Isolierschicht verzichtet werden kann. Die Dicke der Isolierschicht kann sich dann vorteilhafterweise ausschließlich nach der elektrischen Isolationsfähigkeit richten. Damit kann die Isolierschicht besonders dünn ausgelegt werden. Diese ist kostengünstig und besonders einfach zu verarbeiten. Gleichzeitig wird ein guter Wärmeübergang sichergestellt.

Die Isolierschicht kann die Ausnehmung teilweise überdecken. Dadurch wird das Material für die Isolierschicht sparsam eingesetzt. Alternativ ist es auch vorteilhaft, wenn die Isolierschicht die Ausnehmung vollständig bedeckt. Dadurch wird beispielsweise zuverlässig die Ablagerung von Verschmutzung in der Ausnehmung verhindert.

Bei einer vorteilhaften Ausgestaltung der Erfindung ist die erste Oberfläche im Wesentlichen als eine ebene Fläche ausgeführt. Im Wesentlichen bedeutet, dass ein Großteil der ersten Oberfläche, beispielsweise mehr als 80%, als ebene Fläche ausgeführt ist. Neben der ebenen Fläche können Anteile auch von der ebenen Oberfläche abweichen. Zu diesen Anteilen gehören beispielsweise die Ausnehmung, Vorrichtungen zur Befestigung von Grundkörper und Auflagekörper, wie Gewindestangen oder Löcher mit oder ohne Gewinde, sowie Montagevorrichtungen, Griffe bzw. Griffmulden zum Halten oder Transportieren des Grundkörpers. Ein Kühlkörper als Grundkörper kann darüber hinaus mehrere ebene Flächen aufweisen, an der zu kühlende Elemente angebracht werden können. So kann ein Kühlkörper beispielsweise Z-förmig ausgebildet sein und mehrere Teilplatten aufweisen, die miteinander beispielsweise verlötet oder verschweißt sind.

Zumindest im Bereich der vorgesehenen Kontaktfläche mit dem Auflagekörper ist es vorteilhaft, wenn dieser Teil der ersten Oberfläche plan ist. Dadurch kann eine gute anliegende Verbindung erzielt werden, die neben einer hohen mechanischen Stabilität auch beispielsweise einen guten Wärmeübergang sicherstellt. Darüber hinaus kann auch zwischen Grundkörper und Auflagekörper eine Isolierschicht, insbesondere eine Isolierschicht zur elektrischen Isolation, angeordnet werden. Diese stellt sicher, dass auch bei unterschiedlichen elektrischen Potenzialen von Grundkörper und Auflagekörper unerwünschte elektrische Ströme zuverlässig verhindert werden. Durch die ebene Ausgestaltung der ersten Oberfläche des Grundkörpers und der Kontaktfläche des Auflagekörpers wird sichergestellt, dass die Isolierschicht, insbesondere eine Isolierfolie, keine Kräfte oder nur geringe Kräfte erfährt, die zum Reißen der Schicht bzw. Folie führen können. Durch die ebene Oberfläche ergibt sich keine oder nur eine geringe Anforderung an die Reißfestigkeit der Folie bzw. der Isolierschicht.

Bei einer weiteren vorteilhaften Ausgestaltung der Erfindung ist die Ausnehmung derart ausgebildet, dass die Ausnehmung sich vollständig entlang des Bereiches erstreckt, der für die Kontaktierung mit dem Rand der Kontaktfläche des Auflagekörper vorgesehen ist. Der gesamte Rand der Kontaktfläche bildet oftmals das größte Risikopotential für die Entstehung von Kanten und Grate, die ein planes Aufliegen verhindern bzw. eine Beschädigung der Isolierschicht verursachen. Wenn daher der gesamte Rand der Kontaktfläche bei der Kontaktierung des Auflagekörpers mit dem Grundkörper genau auf diese Ausnehmung trifft, liegt der Auflagekörper plan auf dem Grundkörper auf. Falls eine Isolierschicht zwischen Auflagekörper und Grundkörper vorhanden ist, erfährt diese aufgrund der Ausnehmung keine oder nur eine geringe mechanische Belastung. Daher ist es vorteilhaft, dass sich die Ausnehmung entlang des gesamten Rands der Kontaktfläche erstreckt.

Mit dieser Anordnung kann ein gleichmäßiger Druck über den Großteil der Kontaktfläche zwischen Grundkörper und Auflagekörper sichergestellt werden. Dies führt beispielsweise bei einer direkten Kontaktierung unter anderem zu einem guten Wärmeübergang oder bei einer dazwischenliegenden Isolierschicht zu einer gleichmäßigen und moderaten Belastung der Isolierschicht, die zuverlässig und dauerhaft die Isolierschicht vor Beschädigung bewahrt.

Bei einer weiteren vorteilhaften Ausgestaltung der Erfindung ist der Querschnitt der Ausnehmung rechteckförmig oder gerundet ausgeführt. Die Ausnehmung kann besonders einfach rechteckförmig in die erste Oberfläche des Grundkörpers eingebracht werden. Das ist mit Standardwerkzeugen auf einfache Weise möglich. Eine gerundete Querschnittsfläche kann ebenfalls einfach mit Standardwerkzeugen eingebracht werden. Da bei der gerundeten Querschnittsflächen keine Kanten vorhanden sind, wird dadurch gleichzeitig die Verletzungsgefahr bei der Montage reduziert. Ebenfalls besteht bei der Ausgestaltung der Ausnehmung mit einem gerundeten Querschnitt nur eine geringe Gefahr, die Isolierschicht zu beschädigen, insbesondere wenn die Isolierschicht als Folie ausgebildet ist.

Bei einer weiteren vorteilhaften Ausgestaltung der Erfindung ist der Übergang zwischen der Ausnehmung und dem ebenen Teil der ersten Oberfläche gebrochen ausgebildet. Durch die gebrochene Ausbildung kann sichergestellt werden, dass auch der Grundkörper, insbesondere an seiner ersten Oberfläche, keinen Grat aufweist. Mit anderen Worten ist die erste Oberfläche des Grundkörpers gratfrei ausgebildet. Dies stellt sicher, dass Auflagekörper und Grundkörper plan aneinander anliegen und auch eine möglicherweise dazwischenliegende Isolierschicht keine hohe Belastung bzw. hohen Druck erfährt. Somit kann die Gefahr der Beschädigung noch weiter reduziert werden und die Langlebigkeit der isolierenden Wirkung erhöht werden, wenn die Kanten der Ausnehmung gebrochen ausgeführt sind.

Bei einer weiteren vorteilhaften Ausgestaltung der Erfindung ist zwischen dem Grundkörper und dem Auflagekörper eine elektrisch isolierende Schicht angeordnet. Das plane und ebene Anliegen von Grundkörper und Auflagekörper bringt eine äußerst geringe Belastung für eine zwischen dem Grundkörper und dem Auflagekörper angeordneten Isolierschicht mit sich. Es besteht keine oder nur sehr geringe Gefahr des Reißens oder der Durchdringung der Isolierschicht mit sich. Ein Reißen oder Durchdringen hätte den Verlust der isolierenden Wirkung, insbesondere einer elektrisch isolierenden Wirkung, zur Folge. Die Isolierschicht kann dann besonders dünn ausgebildet sein. Gleichzeitig kann sie auch noch einen Teil der Ausnehmung oder die gesamte Ausnehmung überdecken, so dass eine ebene Oberfläche entsteht, die frei von Dreck- und/oder Staubablagerungen ist.

Die beschriebene Ausgestaltung bewährt sich besonders bei Verwendung sehr weicher oder dünner Isolierungen und sehr dicker Auflagekörper, sowie bei aufgebrachter Kraft des Auflagekörpers auf den Grundkörper.

Vorteilhaft ist, wenn sichergestellt werden kann, dass Grund- und Auflagekörper sowie die Isolierung gegeneinander nicht beweglich sind. Dann ist die Belastung der Isolierschicht besonders klein und eine Beschädigung kann auch bei dünner Isolierschicht zumindest nahezu ausgeschlossen werden.

Bei einer weiteren vorteilhaften Ausgestaltung der Erfindung ist die elektrisch isolierende Schicht wärmeleitfähig. Ein besonderer Vorteil der Anordnung liegt darin, dass die Isolierschicht besonders dünn ausgebildet sein kann. Damit eignet sie sich auch im Besonderen, um zwei Körper miteinander zu verbinden, zwischen denen ein Wärmeaustauch erfolgen soll. Ein Beispiel für eine derartige Anwendung ist ein elektrisches oder elektronisches Bauteil als Auflagekörper auf einem Kühlkörper als Grundkörper. Zur elektrischen Isolierung ist oftmals zwischen Bauteil und Kühlkörper eine wärmeleitende Isolierschicht mit elektrisch isolierender Wirkung angeordnet.

Zwar besitzt jeder Stoff eine wenn auch noch so geringe Wärmeleitfähigkeit. An dieser Stelle ist mit wärmeleitfähig eine Wärmeleitfähigkeit von mehr als

$$\lambda = 0,1 \frac{W}{m \cdot K}$$

zu verstehen. Es sind elektrisch isolierende und robuste Materialien für die Isolierschicht verfügbar, die eine entsprechende Wärmeleitfähigkeit aufweisen. Darüber hinaus können für gut wärmeleitende Anforderungen Wärmeleitpads mit einer Wärmeleitfähigkeit von mehr als $\lambda = 10 \frac{W}{m \cdot K}$ eingesetzt werden. Gerade diese sind in ihrer Wärmeleitfähigkeit optimiert und entsprechend empfindlich gegenüber mechanischen Beschädigungen. Somit eignet sich die vorgeschlagene Anordnung insbesondere für eine Isolierschicht mit einer Wärmeleitfähigkeit von mehr als

$$\lambda = 10 \frac{W}{m \cdot K}.$$

Bei einer weiteren vorteilhaften Ausgestaltung der Erfindung wird die elektrisch isolierende Schicht durch eine Folie gebildet. Eine Folie ist besonders einfach in der Produktion einsetzbar und zu verarbeiten. Aufgerollt auf einer Rolle kann im Produktionsprozess die erforderliche Menge einfach zur Verfügung gestellt und verarbeitet werden. Der Nachteil der Gefahr des Reißens der Folie wird durch die Ausnehmung des Grundkörpers zuverlässig vermieden. Somit ist der Einsatz der Folie als Isolierschicht besonders vorteilhaft. Darüber hinaus lassen sich mit einer Folie insbesondere auch besonders hohe Potenzialunterschiede mit nur einer geringen Foliendicke gegeneinander elektrisch isolieren. Darüber hinaus ist der Einsatz einer kleberbeschichteten Folie besonders vorteilhaft. Auch diese ist dünn und weist daher eine besonders gute Wärmeleitfähigkeit auf. Darüber hinaus wird eine Bewegung der Folie gegenüber des Grundkörpers und/oder des Auflagekörpers zuverlässig vermieden. Dies stellt einen dauerhaft guten Wärmeübergang sowie eine dauerhaft gute elektrische Isolation sicher.

Im Folgenden wird die Erfindung anhand der in den Figuren dargestellten Ausführungsbeispiele näher beschrieben und erläutert. Es zeigen:

FIG 1      ein Kontaktsystem aus dem Stand der Technik,

FIG 2      eine Detailansicht des zuvor genannten Kontaktsystems, sowie

FIG 3 und FIG 4      Ausführungsbeispiele eines Kontaktsystems mit vorgeschlagener Ausnehmung.

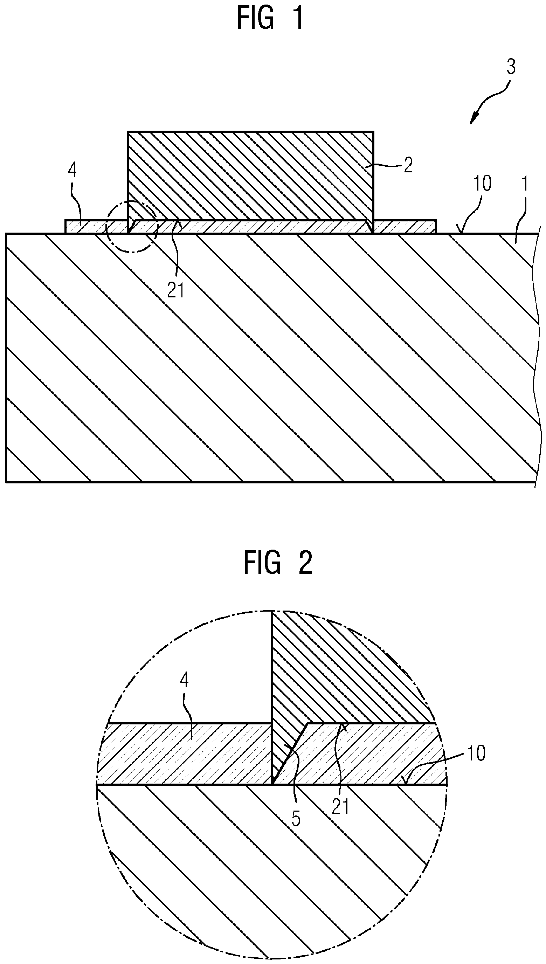

Die FIG 1 zeigt den Querschnitt eines Kontaktsystems 3. Das Kontaktsystemumfasst einen Grundkörper 1 und einen Auflagekörper 2 mit einer zuverlässigen Isolierung mittels einer Isolierschicht 4. Die Isolierschicht 4 ist zwischen dem Grundkörper 1 und dem Auflagekörper 2 angeordnet. Der Grundkörper 1 weist dafür eine erste Oberfläche 10 auf, die für die Kontaktierung mit dem Auflagekörper 2 vorgesehen ist. Der Auflagekörper 2 weist eine Kontaktfläche 21 auf, die für die Kontaktierung mit der ersten Oberfläche 10 des Grundkörpers 1 vorgesehen ist.

Der Übersichtlichkeit halber wurde auf Elemente zur Sicherstellung eines dauerhaften Kontaktes zwischen Grundkörper 1 und Auflagekörper 2 verzichtet. Dies kann beispielsweise durch eine Schraubverbindung, eine Federverbindung, einen Spannverband oder ähnliches realisiert werden. Bei dem Grundkörper 1 kann es sich beispielsweise um einen Kühlkörper handeln. Der Auflagekörper 2 kann beispielsweise durch ein Halbleitermodul oder eine Stromschiene gebildet werden. Beispielsweise bei einem Kontaktsystem 3 aus Kühlkörper und Stromschiene muss zusätzlich dafür gesorgt werden, dass es aufgrund unterschiedlicher elektrischer Potenziale nicht zu Ausgleichsströmen zwischen Grundkörper 1 und Auflagekörper 2 kommt. Grundkörper 1 und Auflagekörper 2 werden daher mittels der Isolierschicht 4 elektrisch voneinander isoliert. Dadurch werden unerwünschte Ausgleichsströme zwischen diesen Körpern 1,2 unterbunden.

Das Kontaktsystem 3 hat somit einen dreischichtigen Aufbau aus dem Grundkörper 1 mit einem ersten elektrischen Potenzial, einer Isolationsschicht 4 und einem Auflagekörper 2, der ein zweites elektrisches Potenzial führt, wobei sich im allgemeinen das erste und das zweite elektrische Potenzial voneinander unterscheiden. Der Aufbau dieses Ausführungsbeispiels dient beispielsweise der Entwärmung einer Stromschiene über einen Kühlkörper.

Die FIG 2 ist eine Detailansicht des in FIG 1 dargestellten kreisförmigen Bereichs am linken Rand des Auflagekörpers 2. Zur Vermeidung von Wiederholungen wird auf die Beschreibung zur FIG 1 sowie auf die dort eingeführten Bezugszeichen verwiesen. Vom Auflagekörper 2 wird dabei angenommen, dass er einen die reguläre Bauteilgeometrie überragenden geometrischen Fehler, beispielsweise einen Grat 5, aufweist. Dieser Fehler kann die Isolierschicht 4 beim Aufpressen oder Aufdrücken des Auflagekörpers 2 auf den Grundkörper 1 entweder vollständig durchdringen, was einen elektrischen Kontakt von Grundkörper 1 und Auflagekörper 2 und damit eine unerwünschte elektrische Verbindung der zu trennenden Potenziale zur Folge hätte. Er kann die Isolierschicht 4 aber auch nur teilweise durchdringen, wodurch der Kontakt, beispielsweise durch Setz- oder Teilentladungseffekte, erst zeitverzögert auftreten kann und in Tests möglicherweise nicht sicher erkannt werden kann.

Besonders kritisch wirkt sich der Fehler aus, wenn die Isolierschicht 4 sehr dünn und/oder weich ist, was beispielsweise bei begrenztem Bauraum oder der Notwendigkeit für einen Wärmedurchgang gegeben ist.

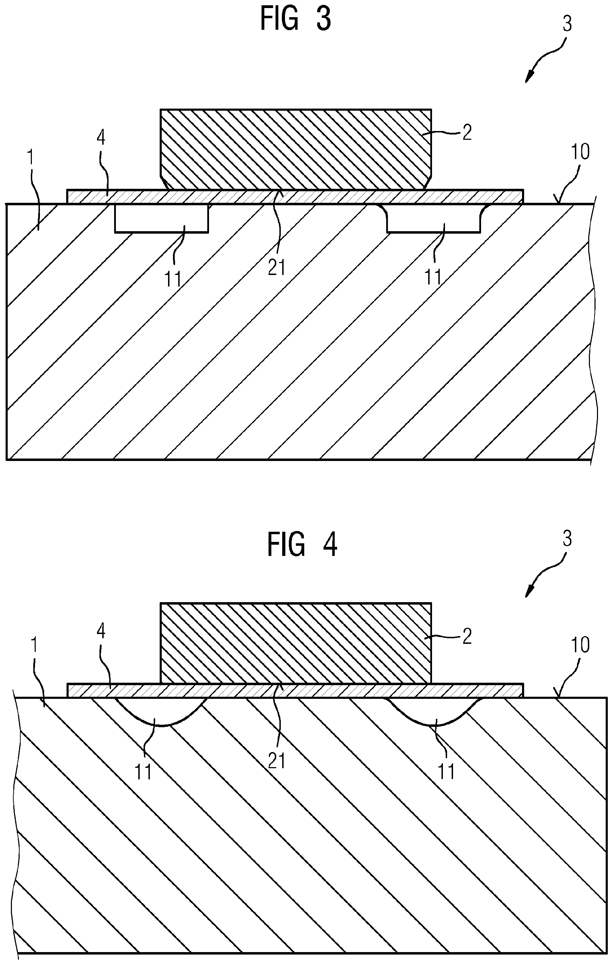

Die FIG 3 zeigt ein Ausführungsbeispiel des vorgeschlagenen Kontaktsystems 3 im Querschnitt. Zur Vermeidung von Wiederholungen wird auf die Beschreibung zu den Figuren 1 und 2 sowie auf die dort eingeführten Bezugszeichen verwiesen. In diesem Ausführungsbeispiel sind im Grundkörper 1 Ausnehmungen 11 in der ersten Oberfläche 10 eingebracht. Diese wirken vorhandenen geometrischen Fehlern wie beispielsweise einem Grat 5 des Auflagekörpers 1 entgegen.

Der Auflagekörper 2 weist idealerweise gemäß seiner Spezifikation zum Schutz vor Beschädigungen der Isolierschicht 4 gebrochene Kanten auf. Dabei ist in der Darstellung der FIG 3 die rechte Kante des Auflagekörpers 2 am Übergang zur Kontaktfläche 21 als gefaste Kante ausgebildet und die linke Kante des Auflagekörpers 2 am Übergang zur Kontaktfläche 21 als gerundete Kanten ausgebildet. Dies stellt jedoch keinen zuverlässigen Schutz vor überragenden Teilen des Auflagekörpers 2 dar. Die Gefahr der Beschädigung ist damit zwar reduziert, jedoch nicht beseitigt.

Daher wird zur Verbesserung des Kontaktsystems 3 im Hinblick auf eine elektrisch isolierende Kontaktierung vorgeschlagen, eine oder mehrere Ausnehmungen an der ersten Oberfläche 10 des Grundkörpers 1 vorzusehen. Diese sind in der Lage, überragenden geometrische Fehler, wie beispielsweise einen Grat 5, aufzunehmen, ohne einen Druck auf die dazwischenliegende Isolierschicht 4 auszuüben. Dies bietet einen zuverlässigen Schutz der Isolierschicht 4, indem die Ausnehmungen 11 der Isolierschicht 4 die Möglichkeit geben, sich bei aufliegenden Graten 5 oder anderen hervorstehenden Geometriefehlern in einen Hohlraum der Ausnehmung 11 zurückzuziehen. Die dadurch stark verringerte Kraftwirkung auf die Isolierschicht 4 verhindert ein Verletzen oder gar Durchdringen der Isolierschicht 4 durch den Auflagekörper 2. Der Hohlraum wird durch eine Materialausnehmung, als Ausnehmung 11 bezeichnet, im Grundkörper 1 gebildet. Diese befindet sich vorteilhafterweise bei einem Kontaktsystem 3 an der Kante der Kontaktfläche 21 des Auflagekörpers 1. Sie kann insbesondere einen rechteckig geformten Querschnitt haben, wie es in der linken Ausnehmung 11 dargestellt ist. Alternativ oder ergänzend ist es auch möglich, die Ausnehmung 11 mit einem gerundeten Querschnitt, insbesondere am Übergang zur ersten Oberfläche 10, auszuführen. Darüber hinaus sind auch andersartig geformte Querschnitte für die Ausnehmung 11 möglich und sinnvoll.

Die Isolierschicht 4 kann den Hohlraum, wie dargestellt, vollständig, alternativ aber auch nur teilweise überdecken.

Darüber hinaus zeigt die FIG 4 den Querschnitt eines weiteren Ausführungsbeispiels mit einem ovalen Querschnitt der Ausnehmung 11. Zur Vermeidung von Wiederholungen wird für die Erläuterung der FIG 4 auf die Beschreibung zu den Figuren 1 bis 3 sowie auf die dort eingeführten Bezugszeichen verwiesen. Vorteilhafterweise verfügt der Grundkörper 1 über eine gebrochene Kante, insbesondere auf der durch den Auflagekörper 2 überragten Seite. Dies reduziert noch einmal die Belastung auf die Isolierschicht 4. Gerade für den Fall, dass die Isolierschicht 4 die gesamte Ausnehmung 11 überdeckt, hat es sich als vorteilhaft erwiesen, zusätzlich auch auf der gegenüberliegenden Seite der Ausnehmung die Kante als eine gebrochene Kante auszuführen. Die gebrochene Kante verhindert ein Eindringen des Grundkörpers 1 in die Isolierschicht.

Zusammenfassend betrifft die Erfindung einen Grundkörper, wobei der Grundkörper zur Kontaktierung, insbesondere zur elektrisch isolierten Kontaktierung, mit einem Auflagekörper eine erste Oberfläche aufweist. Zur Verbesserung der Kontaktierung wird vorgeschlagen, dass die erste Oberfläche mindestens eine Ausnehmung aufweist, wobei die Ausnehmung zumindest abschnittsweise in einem Bereich der ersten Oberfläche angeordnet ist, der für die Kontaktierung mit dem Auflagekörper vorgesehen ist. Die Erfindung betrifft weiter ein Kontaktsystem aufweisend einen derartigen Grundkörper und ein Auflagekörper, wobei eine Kontaktfläche des Auflagekörpers derart an dem Grundkörper angeordnet ist, dass die Ausnehmung des Grundkörpers sich entlang des Randes der Kontaktfläche erstreckt. Ferner betrifft die Erfindung ein Verfahren zur Herstellung eines derartigen Kontaktsystems, wobei der Auflagekörper derart auf dem Grundkörper platziert wird, dass der Rand der Kontaktfläche des Auflagekörpers sich entlang der Ausnehmung des Grundkörpers erstreckt.

**Patentansprüche**

1. Grundkörper (1), wobei der Grundkörper (1) zur Kontaktierung mit einem Auflagekörper (2), insbesondere zur elektrisch isolierten und/oder wärmeleitenden Kontaktierung mit einem Auflagekörper (2), eine erste Oberfläche (10) aufweist, wobei die erste Oberfläche (10) mindestens eine Ausnehmung (11) aufweist, wobei die Ausnehmung (11) zumindest abschnittsweise in einem Bereich der ersten Oberfläche (10) angeordnet ist, der für die Kontaktierung mit dem Rand einer Kontaktfläche (21) des Auflagekörpers (2) vorgesehen ist.

2. Grundkörper (1) nach Anspruch 1, wobei die erste Oberfläche (10) im Wesentlichen als ebene Fläche ausgeführt ist.

3. Grundkörper (1) nach einem der Ansprüche 1 oder 2, wobei die Ausnehmung (11) derart ausgebildet ist, dass die Ausnehmung (11) sich vollständig entlang des Bereiches erstreckt, der für die Kontaktierung mit dem Rand der Kontaktfläche (21) des Auflagekörper (2) vorgesehen ist.

4. Grundkörper (1) nach einem der Ansprüche 1 bis 3, wobei der Querschnitt der Ausnehmung (11) rechteckförmig oder gerundet ausgeführt ist.

5. Grundkörper (1) nach einem der Ansprüche 1 bis 4, wobei der Übergang zwischen der Ausnehmung (11) und dem ebenen Teil der ersten Oberfläche (10) gebrochen ausgebildet ist.

6. Kontaktsystem (3) aufweisend einen Grundkörper (1) nach einem der Ansprüche 1 bis 5 und einen Auflagekörper (2), wobei eine Kontaktfläche (21) des Auflagekörpers (2) derart an dem Grundkörper (1) angeordnet ist, dass die Ausnehmung (11) des Grundkörpers (1) sich zumindest abschnittsweise entlang des Randes der Kontaktfläche (21) erstreckt.

7. Kontaktsystem (3) nach Anspruch 6, wobei zwischen dem Grundkörper (1) und dem Auflagekörper (2) eine elektrisch isolierende Schicht (4) angeordnet ist.

8. Kontaktsystem (3) nach Anspruch 7, wobei die elektrisch isolierende Schicht (4) wärmeleitfähig ist.

9. Kontaktsystem (3) nach einem der Ansprüche 7 oder 8, wobei die elektrisch isolierende Schicht (4) durch eine Folie gebildet wird.

10. Verfahren zur Herstellung eines Kontaktsystems (3) nach einem der Ansprüche 6 bis 9, wobei der Auflagekörper (2) derart auf dem Grundkörper (1) platziert wird, dass zumindest ein Teil des Randes der Kontaktfläche (21) des Auflagekörpers (2) sich zumindest abschnittsweise entlang der Ausnehmung (11) des Grundkörpers (1) erstreckt.

# FIG 1

# FIG 2

# FIG 3

# FIG 4

**Europäisches Patentamt**
**European Patent Office**
**Office européen des brevets**

## EUROPÄISCHER RECHERCHENBERICHT

Nummer der Anmeldung

EP 20 18 9973

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2019/027421 A1 (OMRON CORPORATION) 24. Januar 2019 (2019-01-24) | 1-6,10 | INV. H01L23/367 |
| A | * Zusammenfassung * <br> * Abbildungen 1,2,5 * <br> * Absatz [0014] * <br> * Absätze [0030] - [0031] * | 7-9 | |
| X | US 2016/276245 A1 (MITSUBISHI ELECTRIC CORP) 22. September 2016 (2016-09-22) <br> * Abbildungen 8,13 * <br> * Absätze [0083], [0086] * <br> * Absätze [0104] - [0106] * | 1-10 | |
| A | EP 2 693 471 A2 (TOSHIBA LIGHTING & TECHNOLOGY [JP]) 5. Februar 2014 (2014-02-05) <br> * Zusammenfassung * <br> * Abbildung 1D * | 1-10 | |
| A | US 2016/322274 A1 (TAKIZAWA NAOKI [JP]) 3. November 2016 (2016-11-03) <br> * Abbildungen 1a, 3,4,5 * | 1-10 | RECHERCHIERTE SACHGEBIETE (IPC) <br><br> H01L |

Der vorliegende Recherchenbericht wurde für alle Patentansprüche erstellt

| Recherchenort | Abschlußdatum der Recherche | Prüfer |
|---|---|---|
| Den Haag | 25. Januar 2021 | Deconinck, Eric |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 20 18 9973

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-01-2021

| Im Recherchenbericht angeführtes Patentdokument | Datum der Veröffentlichung | Mitglied(er) der Patentfamilie | Datum der Veröffentlichung |
|---|---|---|---|
| US 2019027421 A1 | 24-01-2019 | EP 3327768 A1 | 30-05-2018 |
| | | JP 6790432 B2 | 25-11-2020 |
| | | JP 2017191903 A | 19-10-2017 |
| | | KR 20180019221 A | 23-02-2018 |
| | | US 2019027421 A1 | 24-01-2019 |
| | | WO 2017179264 A1 | 19-10-2017 |
| US 2016276245 A1 | 22-09-2016 | CN 105900229 A | 24-08-2016 |
| | | DE 112014006113 T5 | 27-10-2016 |
| | | JP 6214678 B2 | 18-10-2017 |
| | | JP WO2015102046 A1 | 23-03-2017 |
| | | US 2016276245 A1 | 22-09-2016 |
| | | WO 2015102046 A1 | 09-07-2015 |
| EP 2693471 A2 | 05-02-2014 | CN 202817020 U | 20-03-2013 |
| | | EP 2693471 A2 | 05-02-2014 |
| | | JP 2014029967 A | 13-02-2014 |
| | | TW 201405730 A | 01-02-2014 |
| | | US 2014034993 A1 | 06-02-2014 |
| US 2016322274 A1 | 03-11-2016 | CN 105900231 A | 24-08-2016 |
| | | DE 112015000253 T5 | 24-11-2016 |
| | | JP 6191775 B2 | 06-09-2017 |
| | | JP WO2016009741 A1 | 27-04-2017 |
| | | US 2016322274 A1 | 03-11-2016 |
| | | WO 2016009741 A1 | 21-01-2016 |

EPO FORM P0461

Für nähere Einzelheiten zu diesem Anhang : siehe Amtsblatt des Europäischen Patentamts, Nr.12/82